Europäisches Patentamt

European Patent Office

Office européen des brevets

(11) Publication number: **0 106 413**
**B1**

(12) **EUROPEAN PATENT SPECIFICATION**

(45) Date of publication of patent specification: **18.01.89**

(21) Application number: **83201468.2**

(22) Date of filing: **14.10.83**

(51) Int. Cl.⁴: **H 01 L 27/08**, G 05 F 3/20

(54) Semiconductor structure having a voltage level shifter.

(30) Priority: **18.10.82 US 435141**

(43) Date of publication of application:
**25.04.84 Bulletin 84/17**

(45) Publication of the grant of the patent:
**18.01.89 Bulletin 89/03**

(84) Designated Contracting States:
**CH DE FR GB LI NL**

(56) References cited:
**GB-A-2 015 206**
**US-A-4 152 716**
**US-A-4 163 161**

**PATENTS ABSTRACTS OF JAPAN, vol. 5, no.
163 (E-78)835r, 20th October 1981; & JP - A - 56
93 360 (MITSUBISHI DENKI K.K.) 28-07-1981**

**PATENTS ABSTRACTS OF JAPAN, vol. 5, no.
34 (E-48)706r, 4th March 1981; & JP - A - 55 160
461 (TOKYO SHIBAURA DENKI K.K.) 13-12-1980**

(73) Proprietor: **N.V. Philips' Gloeilampenfabrieken
Groenewoudseweg 1
NL-5621 BA Eindhoven (NL)**

(72) Inventor: **Simmons, George Houston
c/o INT. OCTROOIBUREAU B.V. Prof. Holstlaan 6
NL-5656 AA Eindhoven (NL)**

(74) Representative: **Veerman, Jan Willem et al
INTERNATIONAAL OCTROOIBUREAU B.V. Prof.
Holstlaan 6
NL-5656 AA Eindhoven (NL)**

Courier Press, Leamington Spa, England.

## Description

This invention relates generally to semiconductor structures and electronic circuits for voltage level shifters and more particularly to an integrated semiconductor structure comprising a semiconductor body and having a voltage level shifter with one or more enhancement-mode field effect transistors, each of said field effect transistors having a source, a drain, a channel region extending therebetween and a gate electrode for controlling a main current path of said field effect transistor which connects said source to said drain, said gate electrode being coupled to said drain, a circuit path connecting an input node to an output node and comprising said main current path of each of said one or more field effect transistors, in said circuit path each of said one or more field effect transistors having its source connected nearer to said input node than its drain, said source and drain being of a first conductivity type and being accommodated in a semiconductive substrate region of said semiconduchor body. Integrated semiconductor structures of this kind are described in U.S. Patent 4,163,161.

## Background art

Some conventional circuits employ a chain of like-polarity insulated-gate field-effect transistors (FET's) responsive to an input voltage for providing an output voltage at a different level. Each FET has its drain connected to its gate electrode.

In U.S. Patent 4,152,716 S. Torii et al disclose a metal-oxide semiconductor (MOS) circuit in which the chain of FET's is a conductive voltage divider. The drain of the FET at one end of the chain receives the input voltage, while the source of the FET at the other end is grounded. The output voltage is taken from one of the FET electrodes between the ends of the chain. The FET's are operated in deep saturation, such that the output voltage is a given fraction of the input voltage depending on the effective FET conductances. Although this voltage divider appears to provide good voltage division, operation is not open ended because the source of FET at the second end of the chain must be tied to a fixed voltage. This is disadvantageous in low-power applications such as CMOS.

Each of the serially-connected FET's in this voltage divider of Torii et al is typically an N-channel device whose source and drain lie in its own P well. The source of each FET is short-circuited to its well. All the P wells lie along the surface of the N-type semiconductor substrate shown as tied to the input voltage. The greatest reverse voltage difference across any PN junction in the structure exists between the substrate at the input voltage and the particular well at ground, rather than along the boundary for the source of the FET in this well which would be the case in the absence of the wells. This voltage difference is limited to the well-substrate junction breakdown voltage $V_{BDW-S}$. It is typically significantly larger than the breakdown voltage $V_{BDS/D}$ of the PN junctions at the source/drain boundaries. As a result, the wells enable the input voltage to exceed ground by more than $V_{BDS/D}$.

Torii et al also describe another MOS voltage divider containing a chain of N-channel FET's whose sources and drains all lie in a single P well along the surface of an N-type semiconductor substrate. This divider differs from the previous one in that Torii et al recite that the input voltage is supplied to the gate electrode of each FET in this divider. Here, the input voltage cannot exceed ground by $V_{BDS/D}$ or more.

In U.S. Patent 4,163,161, referred to in the preamble of this description W. Walker discloses another MOS circuit which produces an output voltage at a specified level by using a chain of N insulated-gate enhancement-mode FET's, each having its drain connected to its gate electrode. These FET's are preferably P-channel devices that form part of the feedback loop in a voltage regulator. The regulated voltage is supplied as the input voltage to the source of the first FET at one end of the chain. The output voltage is supplied from the drain of the last or Nth FET at the other end at a voltage level which differs from the input (regulated) voltage by an amount equal to the composite FET threshold voltage i.e., the sum of the threshold voltages of the individual FET's. The output voltage controls one NPN bipolar transistor which, in turn, so controls another NPN bipolar transistor whose emitter is connected to the source of the first FET as to stabilize the input voltage at a level depending on the composite threshold voltage. Although Walker always employs at least two FET's in his chain, its principle of operation appears applicable to the situation in which there is only one FET.

Walker discloses that the FET's are formed in a conventional manner with their P-type sources and drains lying along the surface of an N-type semiconductive substrate region of a semiconductor body. If, the substrate region is held at the input voltage, the difference between the (input) voltage of the substrate region and the output voltage at the drain of the Nth FET is then the greatest reverse voltage difference that exists across any PN junction in the structure. This voltage difference is limited to $V_{BDS/D}$. That is, the output voltage can differ from the substrate voltage by no more than $V_{BDS/D}$ so as to correspondingly limit the maximum value of the input voltage. This is disadvantageous where a higher value of the input voltage is needed.

## Disclosure of the invention

The invention encompasses a semiconductor structure in which a voltage level shifter has N enhancement-mode FET's, each having its drain coupled to its gate electrode. The FET's are designated sequentially as the first FET through the Nth FET, which are the same in the situation where N equals one. An input voltage is supplied to the source of the first FET. An output voltage at a different level is provided from the drain of the Nth FET. The FET's are of like polarity in the situation where N is greater than one with the drain of each FET except the Nth FET coupled to the source of the next FET.

In the structure, the source and drain of each FET lie in a semiconductive substrate region of a semi-conductor body. The substrate region is of a first conductivity type and contains a primary well of a second conductivity type opposite to the first conductivity type. The source and drain of each FET are of the first conductivity type and lie in the well.

A primary diode formed by the well and substrate region is coupled between a supply of a substantially fixed reference voltage and the channel of each FET. The conductive direction in which the diode is connected is such as to reverse bias it with the circuit so arranged that the absolute value of the difference between the input and reference voltages exceeds the absolute value of the difference between the output and reference voltages.

The well and consequently the channel of each FET are preferably maintained at the input voltage. In this way, the difference between the input voltage at the well and the voltage of the substrate region is the greatest reverse voltage difference that occurs across any PN junction in the structure. This difference is limited to $V_{BDW-S}$ which, as previously mentioned, is significantly higher than $V_{BDS/D}$. Accordingly, the input voltage is not fixed at the substrate voltage. This provides a greater voltage operating range than in the Walker device. Within the well, the difference between the input and output voltages at the drain boundary of the Nth FET is the largest reverse voltage difference across any of the source/drain boundaries. As a result, the output voltage should differ from the input voltage by no more than $V_{BDS/D}$.

The output voltage equals the input voltage plus the composite threshold voltage of the N FET's. This provides open-ended operation so as to avoid the low-power disadvantage of Torii et al. Where N is greater than one, this is suitably achieved by making the drain of each FET except the Nth FET substantially integral with the source of the next FET.

The present structure is suited for application where the substrate region contains a device well of the second conductivity type. The source and drain of a like-polarity device FET lie in the device well. The input voltage is typically an external supply voltage, while the output voltage is a level-shifted on-chip supply voltage provided to the source of this FET and normally also to the device well. If the drain voltage of this FET can go to the substrate voltage (which is the reference voltage in the integrated circuit), the difference between the output and substrate voltages is thereby limited to $V_{BDS/D}$. This is significantly better than that available with Walker.

Since the structure already contains at least two wells, it is readily adapted for CMOS by simply including the source and drain of an opposite-polarity FET in the substrate region outside the wells. Each FET is an insulated-gate device whose source and drain are located along a surface of the substrate region.

Desirably, the input voltage does not serve as a supply for any other on-chip devices. The difference between the input and substrate voltages is then constrained to a maximum of about $2V_{BDS/D}$. This is also significantly better than that available with Walker.

Alternatively, the substrate region contains a second device well of the second conductivity type. The source and drain of a like-polarity second device FET lie in the second device well. The input voltage is provided to the source of this FET and normally also to the second device well. If the drain voltage of this FET can go to the substrate voltage, the difference between the input and substrate voltages is further constrained to $V_{BDS/D}$. This alternative thus provides additional design flexibility at the loss of operating range.

Brief description of the drawings

Figure 1 is a cross-sectional side view of a CMOS structure containing a voltage level shifter as in the invention.

Figure 2 is a circuit diagram of the structure of Figure 1.

Figure 3 is a circuit diagram containing the elements of Figure 2 plus an additional device operated from the input voltage.

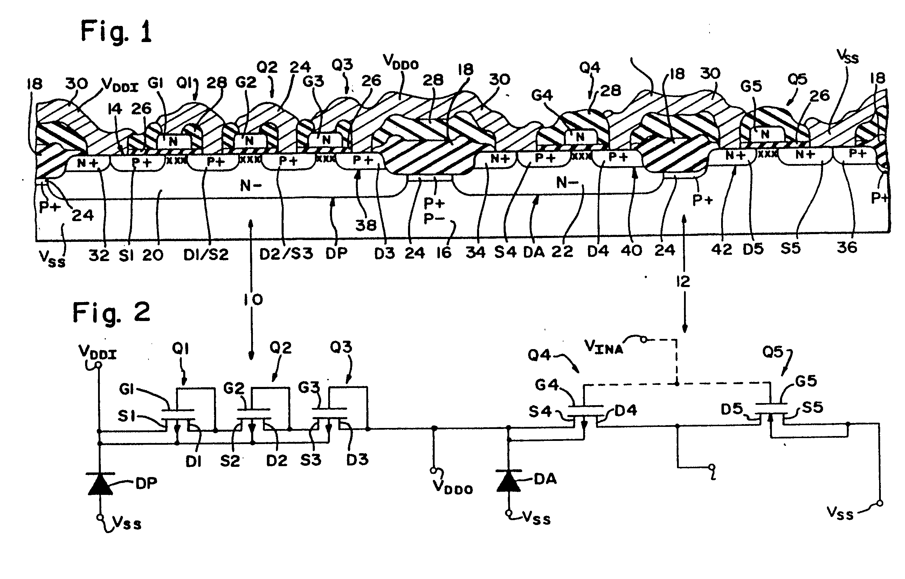

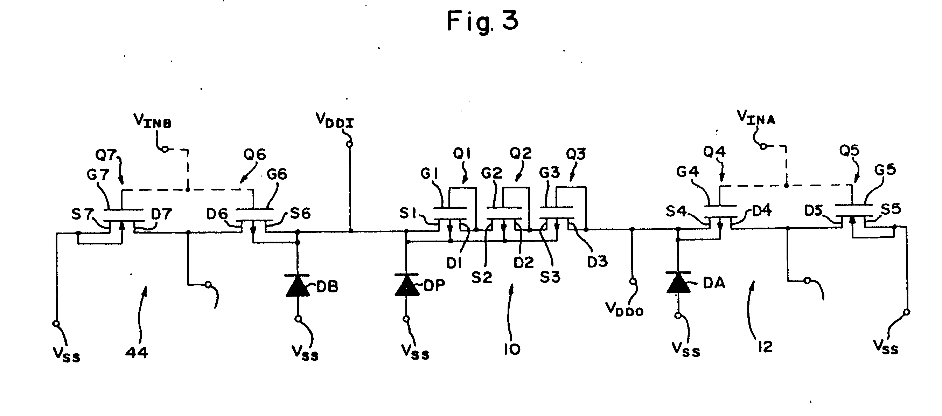

Like reference symbols are employed in the drawings and in the description of the preferred embodiments to represent the same or very similar item or items. Each reference symbol in Figure 1 for a pair of elements formed integrally with each other is a composite symbol consisting of the individual symbols of Figure 2 or 3 separated by a slash.

The electrical connections in dotted lines in Figure 2 or 3 represent connections not shown in Figure 1.

Description of the preferred embodiments

Referring to the drawings, Figure 1 illustrates an embodiment of a CMOS structure having a voltage level shifter 10 that converts an external input supply voltage $V_{DDI}$ into an on-chip output supply voltage $V_{DDO}$ at a lower voltage level. This structure also contains a conventional CMOS inverting device 12 which operates between voltage $V_{DDO}$ and a substantially fixed reference voltage $V_{SS}$ which is lower than $V_{DDO}$. Figure 2 shows the corresponding circuit diagram for level shifter 10 and inverter 12.

Level shifter 10 consists of N-serially-connected P-channel enhancement-mode insulated-gate FET's where N is a positive integer. Figures 1 and 2 show, for example, three such FET's Q1, Q2, and Q3. Each has its drain D1, D2 or D3 connected back to its gate electrode G1, G2 or G3, respectively. Voltage $V_{DDI}$ is supplied to the source S1 of the first FET Q1, while voltage $V_{DDO}$ is taken from drain D3 of the third (or Nth) FET Q3. The channel of each FET Q1, Q2, or Q3 is short-circuited back to voltage $V_{DDI}$. Notably, the channels and thus source S1 are also connected to the cathode of a reversed-biased primary PN diode DP whose anode is connected to the $V_{SS}$ supply.

Device 12 consists of a pair of enhancement-mode insulated-gate FET's Q4 and Q5 arranged in an inverting configuration with their respective drains D4 and D5 connected together to provide a logical voltage output signal $V_{OUTA}$ of opposite logical value to a logical voltage input signal $V_{INA}$ applied to their respective gate electrodes G4 and G5 which are also connected together. FET Q4 is a P-channel device whose source S4 receives voltage $V_{DDO}$ and whose channel is short-circuited to voltage $V_{DDO}$. The channel and source of FET Q4 are also connected to the cathode of a reverse-biased device PN diode DA whose anode is connected to the $V_{SS}$ supply. FET Q5 is a complementary N-channel device whose source S5 and channel are both maintained at voltage $V_{SS}$.

Turning particularly to Figure 1, shifter 10 and device 12 lie along a generally flat surface 14 of a semi-conductor body containing a P-monocrystalline silicon semi-conductive substrate region 16 in which various P-type, N-type, and electrically insulating regions are formed. P-region 16 is maintained at voltage $V_{SS}$. The monocrystalline conductive elements in shifter 10, inverter 12, and other such on-chip devices are each located in one or more active semiconductor regions laterally separated from one another along surface 14 by portions of a recessed electrically insulating region 18 of silicon dioxide. Oxide-isolating region 18 extends about 6,000 angstroms below surface 14 and about 4,000 angstroms above it as well.

In shifter 10, the drain D1 of FET Q1 is integral with the source S2 of FET Q2, and the drain D2 of FET Q2 is integral with the source S3 of FET Q3. Source/drain elements S1, D1/S2, D2/S3, and D3 are all highly conductive shallow P+ regions located along surface 14 in one active semiconductor region. They all extend about 3,000 angstroms below surface 14 into the underlying silicon.

Importantly, P+ regions S1, D1/S2, D2/S3, and D3 all lie in a deep N-well 20 which extends about 5 microns below surface 14 into substrate region 16 to define diode DP. Well 20 thereby extends downward below the bottom of oxide region 18. Well 20 also laterally extends beyond the side walls of the portion of region 18 that defines the active region for shifter 10.

In device 12, source S4 and drain D4 are highly conductive shallow P+ regions located along surface 14 in one active semiconductor region. Both extend to about the same depth below surface 14 as P+ regions S1, D1/S2, D2/S3, and D3 and lie in a deep N-well 22 that extends to about the same depth as well 20 to define diode DA. Source S5 and drain D5 are highly conductive shallow N+ regions located along surface 14 in another active semiconductor region. Both extend about 3,000 angstroms below surface 14 into substrate region 16.

Directly underlying oxide region 18 and surrounding each well 20 or 22 is a highly conductive P+ region 24 that acts to prevent inversion of the doped silicon along region 18. Anti-inversion region 24 also extends partly up the sidewalls of the portion of region 18 that defines the active region for FET Q5.

As shown by the "X's" in Figure 1, a P-type impurity implanted in the channel of each FET Q1, Q2, Q3, Q4, or Q5 serves to control its threshold voltage.

Overlying the channel for each FET Q1, Q2, Q3, Q4, or Q5 is a corresponding portion of a dielectric layer 26 of silicon dioxide above which is located insulated gate G1, G2, G3, G4, or G5, respectively, of doped polycrystalline silicon (polysilicon). Oxide layer 26 is about 500 angstroms thick. Gates G1—G5 are each about 4,000 angstroms thick.

An electrically insulating layer 28 of 8% phosphorus-doped silicon dioxide (Vapox) having an average thickness of about 1.2 microns overlies oxide region 18 and those portions of dielectric layer 26 not covered by gates G1—G5. Vapox layer 28 also surrounds and partially overlies electrodes G1—G5. An electrically conductive pattern 30 of aluminium with about 1% silicon overlies Vapox layer 28 and extends down to surface 14 through apertures in layers 28 and 26 and also down to electrodes G1—G5 through apertures in layer 28 to provide the appropriate electrical inter-connections between the various elements in shifter 10 and inverter 12. Conductive pattern 30, which is about 1 micron thick, also provides the electrical connections for transmitting voltages $V_{DDI}$, $V_{INA}$ (not indicated in Figure 1), $V_{SS}$, $V_{DDO}$, and $V_{OUTA}$.

The portion of pattern 30 that carries voltage $V_{DDI}$ is coupled to the N-portion of well 20 by a highly conductive shallow N+ region 32 located in well 20 along surface 14 adjacent to source S1 so as to maintain well 20 and thus the Q1, Q2, and Q3 channels at voltage $V_{DDI}$. Similarly, the portion of pattern 30 that transmits voltage $V_{DDO}$ is coupled to the N— portion of well 22 by a highly conductive shallow N+ region 34 located in well 22 along surface 14 adjacent to source S4 so as to maintain well 22 and thus the Q4 channel at voltage $V_{DDO}$. N+ regions 32 and 34 extend to about the same depth as N+ regions D5 and S5. Also, the portion of pattern 30 that carries voltage $V_{SS}$ is coupled to the P-portion of substrate region 16 by a highly conductive shallow P+ region 36 located in region 16 along surface 14 adjacent to source S5 so as to maintain region 16 at voltage $V_{SS}$. P+ region 36 extends to about the same depth as P+ regions S4 and D4.

During the operation of level shifter 10, each FET Q1, Q2, or Q3 is conductive with its gate-to-source voltage just at its threshold conductive level $V_{TJ}$. J varies from 1 to N which is 3 in the present example. Each threshold voltage $V_{TJ}$ is negative inasmuch as FET's Q1—Q3 are P-channel enhancement-mode devices. The source-to-drain voltage drop is $|V_{TJ}|$ for each FET QJ since it is gate-to-drain connected. Voltage $V_{TJ}$ is different for each FET QJ because the source voltage and consequently the channel-to-source voltage are different for each FET QJ. Accordingly, output voltage $V_{DDO}$ equals input voltage $V_{DDI}$ plus the composite FET threshold voltage of shifter 10. In other words,

$$V_{DDO}=V_{DDI}+\sum_{J=1}^{N} V_{TJ}.$$

This equation holds even in the complementary case in which each FET QJ is an N-channel device since $V_{TJ}$ is then positive with the necessary result that $V_{DDO}$ exceeds $V_{DDI}$.

Voltage constraints arise from the breakdown voltages of the various PN junctions. For PN junctions DP and DA which are reverse biased because

$$V_{DDI}>V_{DDO}>V_{SS},$$

their well-substrate breakdown voltage $V_{BDW-S}$ is about 50 volts. The breakdown voltage $V_{BDS/D}$ of the PN junctions along all the source/drain boundaries is about 15 volts since the P+/N− breakdown voltage for the PN junctions of the shallow P+ regions in wells 20 and 22 is about 15 volts, and the N+/P− breakdown voltage for the PN junctions of shallow N+ regions S5 and D5 is about the same.

The greatest reverse PN junction voltage difference in the present structure/circuit is the difference between $V_{DDI}$ and $V_{SS}$ across junction DP. Consequently, $V_{DDI}$ is at least limited to $V_{SS}$ plus $V_{BDW-S}$. Within well 20, the greatest voltage difference is the difference between $V_{DDI}$ and $V_{DDO}$ at the PN junction 38 along the boundary of drain D3. $V_{DDI}$ is thus limited to $V_{DDO}$ plus $V_{BDS/D}$.

Devices such as inverter 12 limit voltage $V_{DDO}$. There is no problem with junction DA because its reverse voltage is always less than that across junction DP since $V_{DDO}<V_{DDI}$. A limitation arises from voltage $V_{OUTA}$ which switches from a logical "1" at $V_{DDO}$ with FET Q4 turned on and FET Q5 turned off to a logical "0" at $V_{SS}$ with FET Q4 turned off and FET Q5 turned on as voltage $V_{INA}$ switches from a "0" (at $V_{SS}$) to a "1" (at $V_{DDO}$), and vice vera. Aside from junction DA, the greatest PN junction voltage difference in inverter 12 is either the difference between $V_{DDO}$ and $V_{SS}$ (when FET Q4 is turned off) at the PN junction 40 along drain D4 or the difference between $V_{DDO}$ and $V_{SS}$ (when FET Q4 is turned on) at the PN junction 42 along drain D5. Either of these differences is limited to about $V_{BDS/D}$, whereby $V_{DDI}$ is limited to $V_{SS}$ plus about $2V_{BDS/D}$. This is the overall guiding constraint on voltage $V_{DDI}$ here because $2V_{BDS/D}$ (about 30 volts) is less than $V_{BDW-S}$ (about 50 volts).

Methods for manufacturing the various elements of the present invention are well known in the semiconductor art. Conventional masking, etching, and cleaning techniques are employed in creating the various doped regions shown in Figure 1. To simplify the discussion, references to the masking, etching, cleaning, and other such well known steps are omitted from the following fabrication discussion.

Boron is utilized as the P-type impurity for creating the various P-type regions. Phosphorus and arsenic are used selectively as the complementary N-type dopants. Other appropriate impurities may be used in place of these dopants. In many of the ion implantation steps, an impurity may be alternatively introduced by diffusion, and vice versa.

The starting material is a wafer containing substrate region 16 which has a resistivity of about 15 ohm-cm. A 500-angstrom layer of silicon dioxide is thermally grown along the top of the wafer. Wells 20 and 22 are created by first selectively ion implantating phosphorus (P+) at a dosage of $5\times10^{12}$ ions/cm² and at an energy of 150 kiloelectron volts (KEV) through the oxide layer into region 16 at the areas intended for wells 20 and 22. The phosphorus is then thermally driven in at 1,150°C to form wells 20 and 22. This also activates the phosphorus. The oxide layer is then removed. Oxide-isolation region 18 and anti-inversion region 24 are then formed according to conventional techniques, boron being selectively implanted at $5\times10^{13}$ ions/cm² into the field areas of the wafer and then being driven downward to form P+ region 24 as oxide region 18 is formed.

The various FET's are now formed by first growing dielectric layer 26 along surface 14 by thermal oxidation. Boron (B+) is selectively implanted at $8\times10^{11}$ ions/cm² and 45 KEV into the channels of the various FET's to set their threshold voltages. A polysilicon layer is deposited on the top of layer 26. Phosphorus is diffused into the polysilicon layer to make it electrically conductive at a sheet resistance of about 20 ohms/square. It is then selectively etched to form gates G1—G5. Using gate G5 to provide self-alignment, arsenic (As+) is implanted at $5\times10^{15}$ ions/cm² and 120 KEV through oxide layer 26 at the areas intended for the shallow N+ regions. They are then formed by thermally driving in the arsenic at 1,050°C. This also activates the arsenic. Using gates G1—G4 to achieve self-alignment, boron (B+) is selectively implanted at $3\times10^{15}$ ions/cm² and 40 KEV through layer 26 at the areas for the shallow P+ regions. After depositing Vapox layer 28, the wafer is annealed at 950°C. This drives in the boron so as to form the shallow P+ regions, activates it, and repairs lattice damage.

Layer 28 and, as appropriate, layer 26 are now selectively etched to form the apertures for the various electrical connections to gates G1—G5 and to the shallow P+/N+ regions along surface 14. Conductive pattern 30 is formed by depositing an appropriate layer of silicon-doped aluminium and selectively etching it. The wafer is then completed by depositing a conventional passivation layer (not shown) on the top of the wafer to provide scratch protection, and forming openings through the passivation layer to expose the external contacts.

Preferably, $V_{DDI}$, $V_{DDO}$, and $V_{SS}$ are about 21

volts, 18 volts, and 0 volt, respectively. The average threshold voltage for the N serially-connected FET's in shifter 10 is preferably −1.5 volts, whereby N is 2.

Although only one level-shifting primary well 20/diode DP has been described in the above structure/circuit, a plurality M of such level-shifting wells/primary diodes could be used in which each level-shifting well contains one or more FET's configured as described above for well 20. The level-shifting wells are then sequentially arranged such that the output voltage from the drain of the last FET in each level-shifting well except the Mth well is the input voltage to the source of the first FET in the next well. The input voltage to the source of the first FET in the first well is the overall input voltage (corresponding to voltage $V_{DDI}$) to the level shifter. The output voltage from the drain of the last FET in the Mth well is the overall output voltage (correspoinding to voltage $V_{DDO}$) from the level shifter.

By appropriate summation, the overall input voltage is constrained in two ways. Firstly, it is limited to the overall output voltage plus $MV_{BDS/D}$. Secondly, it is constrained to $V_{SS}$ plus either $V_{BDW-S}$ or about $(M+1)V_{BDS/D}$, whichever is less. This extends the input voltage range even further than in the case where there is only one well 20.

In an alternative embodiment, the present structure/circuit contains an additional device operated from input voltage $V_{DDI}$. Figure 3 shows a circuit diagram of this alternative in which the additional device is another conventional CMOS inverter 44 which consists of a pair of enhancement-mode insulated-gate FET's Q6 and Q7 arranged in an inverting configuration. Their respective drains D6 and D7 are connected together to provide a logical output voltage $V_{OUTB}$ of opposite logical value to a logical input voltage $V_{INB}$ applied to their respective interconnected gate electrodes G6 and G7. FET Q6 is a P-channel device whose source S6 receives voltage $V_{DDI}$ and whose channel is short-circuited to voltage $V_{DDI}$. The channel and source of FET Q6 are also connected to the cathode of a reverse-biased device PN diode DB whose anode is connected to the $V_{SS}$ supply. FET Q7 is a complementary N-channel device whose source S7 and channel are both maintained at voltage $V_{SS}$.

Except for the fact that inverter 44 operates from voltage $V_{DDI}$ rather than voltage $V_{DDO}$, inverter 44 is the same as inverter 12. Diode DB is defined by a deep N-well arranged the same as well 22 along surface 14. Inverter 44 is fabricated along with and in the same manner as described above for inverter 12 and shifter 10.

While provididng additional flexibility, inverter 44 further limits the operational range for voltage $V_{DDI}$. There is no problem with diode DB because its reverse voltage is always the same as that across diode DP. In fact, diode DB and DP are effectively the same PN junction except that they are formed around separate active semi-conductor regions. The limitation arises from voltage $V_{OUTB}$ which switches from a "1" at $V_{DDI}$ with FET Q6 turned on and FET Q7 turned off to a "0" at $V_{SS}$ with FET Q6 turned off and FET Q7 turned on as voltage $V_{INB}$ switches from a "0" to a "1", and vice versa. Aside from diode DB, the greatest PN junction voltage difference in inverter 12 is either the difference between $V_{DDI}$ and $V_{SS}$ (when FET Q6 is turned off) at the PN junction along drain D6 or the difference between $V_{DDI}$ and $V_{SS}$ (when FET Q6 is turned on) at the PN junction along drain D7. Either of these differences is limited to about $V_{BDS/D}$. Accordingly, $V_{DDI}$ is limited to $V_{SS}$ plus $V_{BDS/D}$ in this alternative.

While the invention has been described with reference to particular embodiments, this description is solely for the purpose of illustration and is not to be construed as limiting the scope of the invention claimed below. For example, semiconductor materials of opposite conductivity type to those described above may be employed to accomplish the same results. An element such as a resistor might be coupled between the drain and gate of one or more of the FET's in the level shifter.

## Claims

1. An integrated semiconductor structure comprising a semiconductor body and having a voltage level shifter with one or more enhancement-mode field effect transistors, each of said field effect transistors having a source, a drain, a channel region extending therebetween and a gate electrode for controlling a main current path of said field effect transistor which connects said source to said drain, said gate electrode being coupled to said drain, a circuit path connecting an input node to an output node and comprising said main current path of each of said one or more field effect transistors, in said circuit path each of said one or more field effect transistors having its source connected nearer to said input node than its drain, said source and drain being of a first conductivity type and being accommodated in a semiconductive substrate region of said semiconductor body, characterized in that said semiconductor substrate region belongs to a reference voltage node of the structure, a diode being conneted between said channel region of each of said one or more field effect transistors and said reference voltage node, said semiconductive substrate region being of the first conductivity type and containing a primary well of a second conductivity which is opposite to said first conductivity type, said source and drain of each of said one or more field effect transistors being arranged in said primary well, a pn-junction separating said primary well from said semiconductive substrate region, which pn-junction forms said diode.

2. A structure as in Claim 1 characterized in that the primary well is maintained substantially at the input voltage.

3. A structure as in Claim 1 or 2 characterized in that an output voltage at said output node substantially equals an input voltage at said input node plus the threshold voltage of each of said one or more field effect transistors.

4. A structure as in Claim 1, 2 or 3 characterized in that the substrate region contains a first device well of the second conductivity type spaced apart from the primary well the source and drain of a like-polarity field effect transistor lie in the device well and the output node is connected to the source of said field effect transistor.

5. A structure as in Claim 4 characterized in that the device well is maintained substantially at the same voltage as said output node.

6. A structure as in Claim 4 or 5 characterized in that the substrate region contains a second device well of the second conductivity type spaced apart from said primary and first device wells, the source and drain of a like-polarity second field effect transistor lie in the second device well, and the input node is connected to the source of said second field effect transistor.

7. A structure as in Claim 6 characterized in that the second device well is maintained substantially at the same voltage as said input node.

8. A structure as in one or more of Claims 1 to 7 characterized in that the substrate region contains the source and drain of an opposite-polarity field effect transistor outside the primary well.

9. A structure as in one or more of Claims 1 to 8, characterized in that each of said one or more field effect transistors is an insulated-gate field effect transistor having its source and drain located along a surface of the primary well.

10. A structure as claimed in one or more of Claims 1 to 9, characterized in that the absolute value of the difference between the voltages at the input and reference nodes exceeds the absolute value of the difference between the voltages at the output and reference nodes.

## Patentansprüche

1. Integrierte Halbleiterstruktur mit einem Halbleiterkörper und einem Spannungspegelverschieber mit einem oder mehrere Feldeffekttransistoren vom Anreicherungstype, wobei jeder dieser Feldeffekttransistoren eine Source-Elektrode, eine Drain-Elektrode, ein sich zwischen denselben erstreckendes Kanalgebiet und eine Gate-Elektrode aufweist zur Steurung einer die Source mit der Drain verbindenen Hauptstromstrecke des Feldeffekttransistors, wobei die Gate-Elektrode mit der Drain gekoppelt ist, und mit einer einen Eingangsknotenpunkt mit einem Ausgangsknotenpunkt verbindenden und die Hauptstromstrecke jedes der genannten Feldeffekttransistoren aufweisenden Schaltungsstrecke, wobei in dieser Schaltungsstrecke die verbundene Source-Elektrode näher bei dem Eingangsknotenpunkt liegt als die Drain-Elektrode jedes der genannten Feldeffekttransistoren, wobei die Source und Drain von einem ersten Leitungstyp sind und in einem Halbleitersubstratgebiet des genannten Halbleiterkörpers untergebracht sind, dadurch gekennzeichnet, dass das Halbleitersubstratgebiet zu einem Bezugsspannungsknotenpunkt der Struktur gehört, wobei eine Diode zwischen dem Kanalgebiet jedes der Feldeffekttransistoren und dem Bezugsspannungsknotenpunkt liegt, wobei das Halbleitersubstratgebiet vom ersten Leitungstyp ist und eine Primärmulde von einem zweiten, dem ersten Leitungstyp entgegengesetzten Leitungstyp aufweist, wobei die Source und Drain jeder der Feldeffekttransistoren in der genannten Primärmulde vorgesehen ist, wobei ein PN-Übergang diese Primärmulde von dem Halbleitersubstratgebiet trennt und die genannte Diode bildet.

2. Struktur nach Anspruch 1, dadurch gekennzeichnet, dass die Primärmulde im wesentlichen auf der Eingangsspannung gehalten wird.

3. Struktur nach Anspruch 1 oder 2, dadurch gekennzeichnet, dass eine Ausgangsspannung an dem Ausgangsknotenpunkt im wesentlichen einer Eingangsspannung an dem Eingangsknotenpunkt samt der Schwellenspannung der Feldeffekttransistoren entspricht.

4. Struktur nach Anspruch 1, 2 oder 3, dadurch gekennzeichnet, dass das Substratgebiet eine in einem Abstand von der Primärmulde liegende erste Anordnungsmulde aufweist, wobei die Source und Drain eines Feldeffekttransistors gleicher Polarität in der Anordnungsmulde liegt und der Ausgangsknotenpunkt mit der Source des genannten Feldeffekttransistors verbunden ist.

5. Struktur nach Anspruch 4, dadurch gekennzeichnet, dass die Anordnungsmulde im wesentlichen auf derselben Pannung wie der Ausgangsknotenpunkt gehalten wird.

6. Struktur nach Anspruch 4 oder 5, dadurch gekennzeichnet, dass das Substratgebiet eine zweite Anordnungsmulde vom zweiten Leitungstyp aufweist, die in einem Abstand von der Primärmulde und der ersten Anordnungsmulde liegt, wobei die Source und Drain eines Feldeffekttransistors gleicher Polarität in der zweiten Anordnungsmulde liegt und der Eingangsknotenpunkt mit der Source des zweiten Feldeffekttransistors verbunden ist.

7. Struktur nach Anspruch 6, dadurch gekennzeichnet, dass die zweite Anordnungsmulde im wesentlichen auf derselben Spannung gehalten wird wie der genannte Eingangsknotenpunkt.

8. Struktur nach einem oder mehreren der Ansprüche 1 bis 7, dadurch gekennzeichnet, dass das Substratgebit die Source und Drain eines Feldeffektransistors entgegengesetzter Polarität ausserhalb der Primärmulde aufweist.

9. Struktur nach einem oder mehreren der Ansprüche 1 bis 8, dadurch gekennzeichnet, dass jeder der Feldeffekttransistoren ein Isolierschicht-Feldeffekttransistor ist, dessen Source und Drain an einer Oberfläche der Primärmulde liegen.

10. Struktur nach einem oder mehreren der Ansprüche 1 bis 9, dadurch gekennzeichnet, dass der Absolutwert der Differenz zwischen den Spannungen am Eingang und an den Bezugsknotenpunkten grösser ist als der Absolutwert der Differenz zwischen den Spannungen an dem Ausgang und den Bezugsknotenpunkten.

## Revendications

1. Structure semiconductrice intégrée comportant un corps semiconducteur et présentant un dispositif de décalage de niveau de tension comportant un ou plusieurs transistors à effet de champ du mode d'enrichissement, chacun desdits transistors à effet de champ présentant une source, un drain, une région à canal s'étendant entre ces derniers et une électrode de porte pour la commande d'un trajet de courant principal desdits transistors à effet de champ qui connecte ladite source audit drain, ladite électrode de porte étant couplée audit drain, un trajet de circuit aussurant la connexion d'un noeud d'entrée à un noeud de sortie et comportant ledit trajet de courant principal, (de chacun) dudit (ou desdits) transistor(s) à effet de champ, dans ledit trajet de circuit la source de chaque (chacune) dudit (desdits) transistor(s) à effet de champ est connectée plus près dudit noeud d'entrée que son drain, lesdits source et drain étant d'un premier type de conductivité et logés dans une région de substrat semiconductrice dudit corps semiconducteur, caractérisée en ce que ladite région de substrat semiconducteur appartient à un noeud de tension de référence de la structure, une diode étant montée entre ladite région de canal (de chacun) dudit (desdits) transistor(s) à effet de champ et ledit noeud de tension de référence, ladite région de substrat semiconducteur étant du premier type de conductivité et contenant un puits primaire d'une deuxième type de conductivité qui est opposé audit premier type de conductivité, lesdits source et drain dudit (de chacun desdits) transistor(s) à effet de champ étant disposés dans ledit puits primaire, une jonction pn séparant lesdits puits primaires de ladite région de substrat semiconducteur, cette jonction pn constituant ladite diode.

2. Structure selon la revendication 1, caractérisée en ce que le puits primaire est maintenu pratiquement à la tension d'entrée.

3. Structure selon la revendication 1 ou 2, caractérisée en ce qu'une tension de sortie audit noeud de sortie est pratiquement égale à une tension d'entrée audit noeud d'entrée augmentée de la tension de seuil dudit (de chacun desdits) transistor(s) à effet de champ.

4. Structure selon la revendication 1, 2 ou 3, caractérisée en ce que ladite région de substrat contient un premier puits (de dispositif) du second type de conductivité qui est séparé du puits primaire, la source et le drain d'un transistor à effet de champ de même polarité étant situés dans le puits de dispositif et le noeud de sortie est connecté à la source dudit transistor à effet de champ.

5. Structure selon la revendication 4, caractérisée en ce que ledit puits de dispositif est maintenu pratiquement à la même tension que ledit noued de sortie.

6. Structure selon la revendication 4 ou 5, caractérisée en ce que la région du substrat contient un deuxième puits (de dispositif) du second type de conductivité qui est séparé desdits puits primaire et premier puits de dispositif, la source et le drain d'un second transistor à effet de champ de même polarité étant situés dans le second puits de dispositif et le noeud d'entrée est connecté à la source dudit transistor à effet de champ.

7. Structure selon la revendication 6, caractérisée en ce que le second puits de dispositif est maintenu pratiquement à la même tension que ledit noeud d'entrée.

8. Structure selon l'une des revendications 1 à 7, caractérisée en ce que la région de substrat contient la source et le drain d'un transistor à effet de champ de polarité opposée à l'extérieur de puits primaire.

9. Structure selon l'une des revendications 1 à 8, caractérisée en ce que ledit (ou chacun desdits) transistors à effet de champ est un transistor à effet de champ à porte isolée dont la source et le drain sont situés le long d'une surface du puits primaire.

10. Structure selon l'une ou plusieurs des revendications 1 à 9, caractérisée en ce que la valeur absolue de la différence entre les tensions aux noeuds d'entrée et de référence dépasse la valeur absolue de la différence entre les tensions aux noeuds de sortie et de référence.

Fig. 1

Fig. 2

Fig. 3